# EUROPEAN PATENT APPLICATION

(11) **EP 4 764 027 A1**
(43) Date of publication of application: **24.06.2026**
(21) Application number: 24221237.1
(22) Date of filing: 18.12.2024
(51) Int. Cl.: C23C 16/04, C23C 16/32, C23C 14/50, C23C 16/458, C04B 35/565, C04B 41/00, C04B 41/45, C04B 41/87, H01L 21/687

(54) **AN ARTICLE CONFIGURED FOR RECEIVING AN OBJECT FOR HIGH TEMPERATURE PROCESSING AND A METHOD OF MANUFACTURING SAID ARTICLE**

(71) Applicant: Schunk Xycarb Technology B.V., 5705 CS Helmond (NL)
(72) Inventor: HOLMWOOD BENITO, Kelly, HELMOND (NL); VAN STRIEN, Bryce, HELMOND (NL); SCHMIDT, Johanna, HELMOND (NL); BEULENS, Sjaak, HELMOND (NL); VAN MUNSTER, Marc, HELMOND (NL)
(74) Representative: Algemeen Octrooi- en Merkenbureau B.V.

(57) **Abstract**

The disclosure pertains to article and a method of manufacturing said article. The article is configured for receiving an object for thermal processing, preferably said object being a semiconductor wafer, wherein the article comprises a porous structure having an internal arrangement corresponding to a fibrous material, said article material being silicon carbide (SiC).

## Description

### TECHNICAL FIELD

The invention pertains to an article configured for receiving an object for high temperature processing, preferably a semiconductor wafer, and a method of manufacturing said article.

### BACKGROUND OF THE DISCLOSURE

Semiconductor wafers are exposed to various processes during their processing to become semiconductor chips. Some of these processes, such as for instance epitaxial deposition, occur at elevated temperatures.

During these high temperature processes, not only the wafer, but also the article holding the wafer is heated. In order to not deform and thereby change the position or orientation of the wafer, the articles holding the wafer have been manufactured previously out of a Carbon (C) core with a Silicon Carbide (SiC) coating layer, trying to match the thermal properties of the wafer.

However, because of the presence of an interface between the C core and the SiC coating and the associated mismatch in thermal properties between the two different materials, these articles are prone to deformation and/or warping upon temperature changes, more so in thermal cycling the warping creating interface stresses could lead to breakage or cracking of the article.

The goal of the current disclosure is to provide an article having a stable shape when going through multiple high-temperature processing cycles by reducing the internal stresses and the effects they have on the macroscopic level.

### SUMMARY OF THE DISCLOSURE

In a first aspect the disclosure pertains to an article configured for receiving an object for thermal processing, preferably said object being a semiconductor wafer, wherein the article comprises a porous structure having an internal arrangement corresponding to a fibrous material, said article material being silicon carbide (SiC).

As laid out in the background section, form-stable articles are indispensable during high temperature processes for holding an object that undergoes a thermal process. The article according to the disclosure is a SiC porous matrix material. It can be understood that the porous structure has an internal arrangement corresponding to a fibrous material, yet the material itself is not fibrous. In other words, there are no individual fibers of SiC present in the article. The internal arrangement could be understood as fibers having cross-linked or being (inter)connected to form an intricate structure, which has pores similar to those of a fibrous network, yet wherein individual fibers are no longer identifiable/moveable/removeable. The internal arrangement of the article according to the disclosure, however, is distinguishable compared to other porous structures, for instance those formed due to internal gas formation. Namely, such porous structures would typically comprise spherical pores. The porous structure of the article according to the disclosure comprises pores which are rather irregularly shaped. They may be elongated or have more defined shapes, but are typically shaped as voids in between fibers, thereby following the original fiber direction and orientation. For instance, parallelepiped pores may be present, wherein each face corresponds to a fiber in a fibrous material, yet they are no (longer) individual fibers. The porosity of the article may serve as a primary steering parameter for its thermal and mechanical macro properties. Open porosity, in particular, may be considered a key feature of the article, contributing to its permeability. This enables controlled diffusion of gaseous molecules through the article, for example making it suitable for processes that benefit from gas exchange or contaminant filtration. The degree of open porosity can be tuned during manufacturing to achieve desired properties, such as specific thermal conductivity or mechanical stability.

These pores may be interconnected, such that diffusion through the article of gaseous molecules is possible. Furthermore, these pores may be randomly oriented based on the original orientation of the corresponding fibers in the fibrous material. Alternatively, in case the corresponding fibers in the fibrous material were oriented, for instance in a woven pattern, the internal arrangement of the porous structure of the article according to the disclosure would also be having that same regular woven pattern. Yet for the porous structure of the article, the individual fibers would all seem to have cross-linked/petrified forming one solid porous material, where individual fibers are no longer present.

An article comprising a porous structure having an internal arrangement corresponding to a fibrous material has been found beneficial by the inventors, because it results in articles having a greater shape stability. Furthermore, the inventors have found that manufacturing the article such that the article is made of substantially pure SiC, no internal stresses would arise during thermal cycling, leading to warpage and breakage, for the articles according to the disclosure.

In an example of an article, the article's purity may be defined by the remaining presence of unreacted or free constituents within the silicon carbide (SiC) matrix; specifically, free Carbon (C) and free Silicon (Si) that are not bonded as SiC. For such articles, the amount of free Carbon (C) is less than 15%wt, preferably less than 10%wt, more preferably less than 5%wt, most preferably less than 2%wt, and the amount of free Silicon (Si) is less than 10%wt, preferably less than 5%wt, more preferable less than 2%wt, most preferable less than 1%wt of the final article, wherein the amount of free Carbon (C) is independent of the amount of free Silicon (Si). In a preferred example, the article according to the disclosure is >90%wt, preferably >95%wt or more preferably >98%wt pure SiC, such that the sum of the amount of remaining Carbon (C) and Silicon (Si) is less than 10%wt, preferably less than 5%wt, more preferably less than 2%wt, respectively.

In another example of an article, the article's purity may be defined by the remaining presence of trace metals, wherein the amount of metal trace material may be limited to less than 100 ppm, preferably less than 50 ppm, and most preferably less than 10 ppm.

Especially with a purity level of less than 50 ppm, preferably less than 10 ppm, or most preferably less than 5 ppm, the invention shows that articles according to the disclosure show much less warping or deformation during thermal cycling, thereby guaranteeing and maintaining the position and orientation of the object that is being carried by the article. This is achieved, because the internal stresses in the porous SiC matrix material are drastically reduced because of the removal of interfaces between materials having different temperature dependent material properties.

Another advantage of said article being made of a porous, yet highly pure, SiC matrix is that the macro properties of the article can be tuned by changing the porosity of the article. That way, the article's properties can be fine-tuned to a specific process, object to-be-carried, and/or specific use-case. Because of this advantage, the article according to the disclosure can be a drop-in replacement for existing articles, wafer carriers and/or susceptors.

Therefore, in a specific example of the article according to the disclosure, the article is a wafer carrier or a susceptor. Namely, these are articles that benefit the most for highly form stable articles, because they are typically subjected to harsh conditions at elevated temperatures.

Two more examples of such articles are: an article for a process chamber for thermal processing, having an upper surface and a lower surface, wherein the upper surface is configured for receiving the object, and an article comprising an inner disc and an outer ring, wherein inner disc is configured for receiving the object.

These are particular examples of beneficial implementations of articles according to the disclosure, since they are commonly being subjected to high-temperature cycling. Furthermore, the disc-shape allows the article to be roughly the size (only slightly larger) than a wafer to-be carried. That way, conformal contact may be made with the wafer, such that an underpressure can be used for maintaining the wafer in position during processing. It may thus be necessary to provide at least one vacuum bore in the article, adapted to be connected to vacuum/underpressure means. Alternatively, a disc and a ring shaped part article may use its circular recess to act as a vacuum/underpressure channel, keeping the wafer in its position. Alternatively, the disc shaped part may be concave shaped, such that the wafer only rests at the outer perimeter of the disc shaped part. That way, a greater vacuum/underpressure pocket can be generated underneath the entire wafer. Furthermore, the outer ring may act as a filter, capturing contaminants in its porous structure. The entire bottom of the article may then be subjected to a vacuum/underpressure.

In another example, the article is at least partially covered by a silicon carbide (SiC) coating layer. The SiC coating may be understood to generate a uniform layer on top of the article, but it may as well fill the pores of the article.

The advantage of providing a SiC coating layer is that the final porosity of the article can be slightly adjusted with the application of a coating layer. Namely, the coating material may infiltrate the exposed pores, thereby filling them and reducing the overall porosity. This would thus allow for retroactively adjusting the macroscopic properties of the article slightly.

Furthermore, utilizing the same material for the coating layer as for the porous structure ensures that there are no material mismatches between the two, such that no or little interfaces may be formed aiding towards the higher form stability of the article.

In another aspect the article configured for receiving an object for thermal processing, preferably said object being a semiconductor wafer, wherein the article comprises a porous structure having an internal arrangement corresponding to a fibrous material, said article may be chosen to be a different material, such as Tantalum Carbide (TaC), Hafnium Carbide (HfC), Titanium Carbide (TiC), Zirconium Carbide (ZrC), Niobium Carbide (NbC) or even Tungsten Carbide (WC).

In an example thereof, the article is at least partially covered by a coating layer selected from a list of Tantalum Carbide (TaC), Hafnium Carbide (HfC), Titanium Carbide (TiC), Zirconium Carbide (ZrC), Niobium Carbide (NbC) or even Tungsten Carbide (WC).

In a preferable example, the coating layer material is the same as the article material.

The expert in the field would thus understand that either the material of the porous structure or the coating layer material or even both could be selected to be a different material and that all other characteristics as summarized in this disclosure are transferable to those cases. These particular materials may be useful in specific use cases of articles for specific purposes.

In a particular example of the article according to the disclosure, a thickness of the coating layer, preferably being SiC, is in a range of 1-500 µm, preferably in a range of 10-250 µm, most preferably in a range of 50-200 µm.

These specific thicknesses of the coating layer ensure that the surface of the article may interact uniformly with the object to be carried, since a thick enough coating layer fills up the pores on the surface of the article as well as levels out the surface of said article.

As previously mentioned, the coating layer may be provided only partially on the article. This can be understood as covering part of one of the surfaces of the article. However, it may also be understood as covering only one of the surfaces of the article, or the entire article. Examples thereof are coverage of only the upper surface or the bottom surface, but even only on the upper or lower surface of only the ring shape or the disc shape.

In an example, the coating layer is provided on the upper and/or lower surface of the article.
And in another example, the coating layer is provided on a lower surface of the outer ring.

Providing the coating layer infiltrating and/or covering the pores may affect the macroscopic properties of the article. However, it may also affect the apparent openness of the pores of the article, especially on the surface. That way contaminants could even be filtered out of a process chamber, wherein the article is being utilized. In that regards, vacuum/underpressure means may be placed underneath the article, such that the entire bottom surface is subjected to a vacuum/underpressure. Because of the porous structure contaminants floating around the process chamber may be drawn towards the bottom side of the article by going through the pores of the article. Because of the high surface area, these contaminants remain in the article and therefore no longer cause hindrance in the processing of the wafer. By tuning the pore size of the article itself, preferably in combination with the presence of a coating layer, the article can be tailored to control the diffusion of active species while maintaining structural stability during processing. Also, adsorbed species may be removed after processing by heating the article and applying an overpressure from the bottom side or surface.

A vacuum/underpressure can be understood throughout this disclosure as not being absolute vacuum, but rather an underpressure being lower than the pressure surrounding the article and/or the object to be carried.

In a further example of the article, the porosity of the article ranges from 5% to 50%, preferably from 15% to 30%.

The article according to the disclosure allows for changing and tuning its overall porosity accurately, thereby affecting other macroscopic properties. Next a few examples of achievable ranges for material properties will be disclosed.

In a first example, the density of the article ranges from 1.6 g·cm⁻³ to 3.2 g·cm⁻³, preferably ranging from 2.0 g·cm⁻³ to 3.0 g·cm³, most preferably ranging from 2.2 g·cm⁻³ to 2.5 g·cm³.

In a second example, the CTE of the article ranges from 4.0·10⁻⁶ to 5.5·10⁻⁶ K⁻¹, preferably ranging from 4.5·10⁻⁶ to 5.0·10⁻⁶ K⁻¹, more preferably being 4.8·10⁻⁶ K⁻¹, wherein the CTE is measured at 1000 °C.

In a third example, the Young's modulus of the article ranges from 80 to 450 GPa, preferably ranging from 150 to 300 GPa.

In a fourth example, the thermal conductivity of the article ranges from 70 to 80 W·m⁻¹·K⁻¹.

In a fifth example, the Specific Heat Capacity (Cₚ) of the article ranges from 600 to 625 J·kg⁻¹·K⁻¹, preferably being around 600 J·kg⁻¹·K⁻¹.

The exact measurement values and the respective measurement method will be further discussed in the detailed description of this disclosure. Importantly, it should become clear to the expert in the field that the macroscopic properties of an article according to the disclosure can be tuned finely within the above-mentioned ranges. It thus allows for adjusting the article to specific wishes or requirements of a user for a given process, wherein the article is intended to be utilized.

A further aspect of the disclosure pertains to a method of manufacturing an article, having an upper surface and a lower surface, wherein the upper surface is configured to receive an object for thermal processing, preferably said object being a semiconductor wafer, the method comprising the steps of:
- providing a porous carbon (C) material, preferably a carbonaceous fibrous material;
- converting substantially all Carbon (C) of the material into Silicon Carbide (SiC) utilizing one or more of the group comprising: Chemical Vapor Reaction (CVR), Liquid Infiltration Reaction (LIR), Liquid Phase Epitaxy (LPE), and Molecular Beam Epitaxy (MBE);
- removing excess Silicon (Si),
- forming the article, such that an object, preferably a semiconductor wafer, can be received.

The step of forming the article may be performed before or after removing excess Silicon (Si), or non-constitutive Silicon Carbide (SiC) matrix material from the article to achieve a high-purity and shape-controlled article. When performed earlier in the process, it may be performed before or during the conversion of Carbon (C) to Silicon Carbide (SiC).

The method according to the disclosure allows for manufacturing articles which are form-stable during high-temperature processing of an object that is being held by the article. Because the article is converted into a highly pure SiC porous matrix material, which can be understood to have an internal arrangement corresponding to a fibrous material, yet the article material itself is no longer fibrous, the article experiences less internal stress than prior art articles. Namely, the amount of material interfaces have drastically been reduced, thereby reducing the internal interface stresses that would occur during high-temperature cycling. These would otherwise result in warpage and ultimately breakage of the article, compromising its form-stability.

The internal arrangement of the porous structure of the article would correspond to the arrangement of the fibers of the carbonaceous fibrous material. These materials come in various fibrous arrangements, wherein fibers are either oriented randomly or are oriented in a woven (having a regular fiber arrangement) manner. During the conversion reaction, this fibrous arrangement is maintained, and the original fibers are converted into highly pure SiC structures following the original fiber orientation. These fiber-like structures may interconnect at locations, where original fibers of the carbonaceous fibrous material would overlap and touch. That way, a seemingly cross-linked fibrous structure may be obtained.

Yet, the articles manufactured according to the method of the disclosure will show to have greater shape stability and additionally allow for tuning of their macroscopic properties. Furthermore, the inventors have found that manufacturing the article such that the article is made of substantially pure SiC, no internal stresses would arise during thermal cycling, thereby circumventing warpage and breakage of the article.

Furthermore, the porosity and thus the macroscopic properties of articles have been found to be tunable by tuning the porosity of the initial carbon material. This would have a final effect on the article that its thermal properties, such as CTE, specific heat capacity, or thermal conductivity can be tuned to match the requirements of the article. Furthermore, other material properties of the article, such as its density, pore size or its Young's modulus can be tuned very precisely.

Forming the article can be understood as shaping an article such that an object, for instance being a semiconductor wafer, can be received on its surface. In that regard, various shapes may be possible depending on the exact application of the article. For instance, the article may be shaped to become disc-like, or said disc may be shaped to only receive the article on its outer perimeter. Alternatively, the article may be shaped to have an inner and an outer part, such that the article can be used in a processing chamber.

The techniques available for shaping may therefore also differ depending on the exact requirements and application of the article. Traditional machining techniques could be useful for fabricating a specific shape for the article, such as a disc comprising an inner disc and an outer ring. However, semiconductor manufacturing techniques, such as sputtering, etching, abrading, grinding, polishing, or deposition techniques may be employed to achieve precise dimensions, surface finishes, or specific structural features tailored to the article's intended function.

Furthermore, it should be noted that the "-" indicate that there is not specific order of the steps according to the disclosure unless otherwise specified. Only obviously the step of "providing the Carbon (C) fibrous material" should be performed as the first step. Furthermore, it should be clear to the skilled person or artisan that the step of "removing excess Silicon (Si) from the article" can only be performed after the step of converting. For instance, the step of forming the article may be performed by shaped the carbon material as desired, or could be performed after conversion of the carbon material into SiC, or could be removal of the excess Si from the article. Hence, in general, any of the steps, e.g. may be performed in any sequence suitable for achieving the desired properties of the article.

The wording "substantially" can be understood as a chemical conversion of a high rate, such rates may be above 90%, preferably above 95%, and more preferably above 98%.

Another example of the method according to the disclosure further comprises a step of providing a coating of Silicon Carbide (SiC) on at least part of the article.

Providing a SiC coating on at least part of the article allows to tune the porosity of the article (locally), and thus the (local) macroscopic article properties as well, since the SiC coating may fill some of the pores of the porous structure. Furthermore, it allows for manufacturing a uniform layer, which may receive the object to be carried by the article.

All in all, the method and the article according to the disclosure allow for manufacturing a more form-stable article for high-temperature processing than prior art articles. This has been achieved by reducing internal stresses of the article by having less interfaces between different materials. Furthermore, because the article according to the disclosure comprises a porous structure its macroscopic properties can be tailored to a specific use case or process for which the article needs to hold an object, making such articles more versatile and useful for users.

### SHORT DESCRIPTION OF THE FIGURES

The disclosure will now be discussed with reference to the drawings, which show in:
Figure 1 shows a three-dimensional view of an article according to the disclosure comprising an inner disc and an outer ring;
Figure 2 shows a three-dimensional view of another article according to the disclosure comprising multiple recesses for carrying objects;
Figure 3 shows a three-dimensional view of yet another article according to the disclosure having a ring shape comprising a plurality of recesses shaped as multiple vortexes;
Figure 4 shows a process flow of a method according to the disclosure;
Figure 5 shows electron micrographs of the article's material according to the disclosure;
Figure 6 shows a cross-section of the article of Fig. 1 inside a process chamber.

### DETAILED DESCRIPTION OF THE DISCLOSURE

For a proper understanding of the disclosure, in the detailed description below corresponding elements or parts of the disclosure will be denoted with identical reference numerals in the drawings.

The disclosure pertains to a method of manufacturing an article and to said article, having an upper surface and a lower surface, wherein the upper surface is configured to receive an object for thermal processing, preferably said object being a semiconductor wafer. The method comprises the steps of:
- providing a porous carbon (C) material, preferably a carbonaceous fibrous material;
- converting substantially all Carbon (C) of the material into Silicon Carbide (SiC) utilizing one or more of the group comprising: Chemical Vapor Reaction (CVR), Liquid Infiltration Reaction (LIR), Liquid Phase Epitaxy (LPE), and Molecular Beam Epitaxy (MBE);
- removing excess Silicon (Si);
- forming the article, such that an object, preferably a semiconductor wafer, can be received.

This results in an article comprising a porous structure having an internal arrangement corresponding to a fibrous material, and wherein article's material is of a high purity silicon carbide (SiC).

The article experiences reduced material interfaces due to the higher final purity that can be achieved. A high final purity can be understood as a chemical conversion reaction of a high rate, resulting in converting over 90%, preferably above 95%, and more preferably above 98% of the starting material in the converted carbide material.

Because of the reduced material interfaces, the article experiences less internal stress, thereby increasing the lifetime of the article. Additionally, the article being made of a highly pure SiC, brings the thermal properties more in line with the object to be carried. Not only the thermal properties are improved, but also the stiffness of the article is improved aiding towards greater shape stability. Furthermore, the article (fabricated by the method of the disclosure) has the advantage that the porosity of the porous structure can be tuned two ways: first by selecting a different starting carbonaceous fibrous material before converting it into SiC or by coating the article after manufacturing with a SiC coating.

Tuning the porosity as a main steering parameter affects the final macroscopic material properties of the article. That way, various articles having various properties can be easily manufactured and tailored towards the needs of the user. Such material properties include the stiffness, thermal conductivity, thermal mass, flexibility, density, etc. of the article.

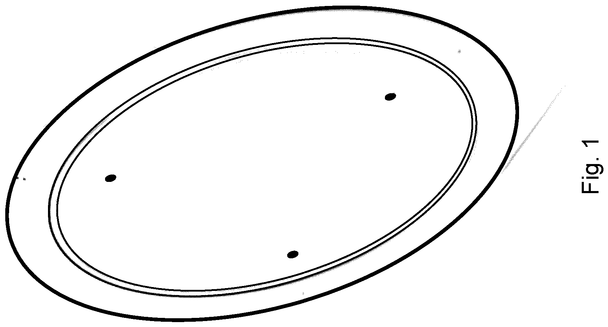

In Fig. 1, a first example of an article according to the disclosure is shown. An upright three-dimensional representation can be seen comprising of an inner disc having at least one, preferably three, openings configured to guide lifting pins therethrough. Furthermore, the article comprises an outer ring, which is distinctly separated from the inner disc by a circular recess. Such article may also be known as a susceptor for wafers for in a process chamber. Namely, the wafer can be carried by the susceptor and released with the three lifting pins. A wafer may be carried solely by the inner disc, but could also be partially carried by the outer ring, thereby covering the circular recess.

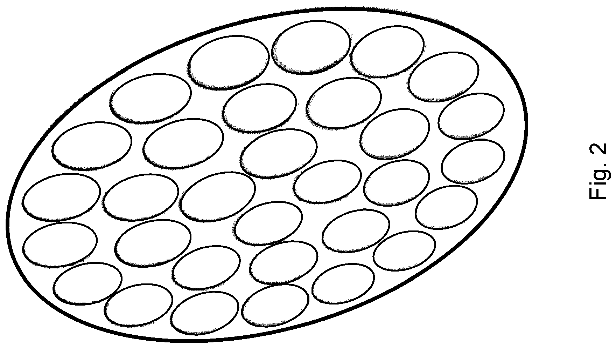

In Fig. 2, a second example of an article according to the disclosure is shown. Herein, an upright three-dimensional representation of an article comprising a plurality of carrier recesses is shown. Each of these carrier recesses is configured to receive an object, preferably a semiconductor wafer, to be carried. The recesses are slightly wider than the diameter of the object to be carried, such that they nicely fit. Furthermore, this would allow the objects to remain in their intended position nicely, since they are mechanically obstructed by the side walls of the carrier recesses to translate.

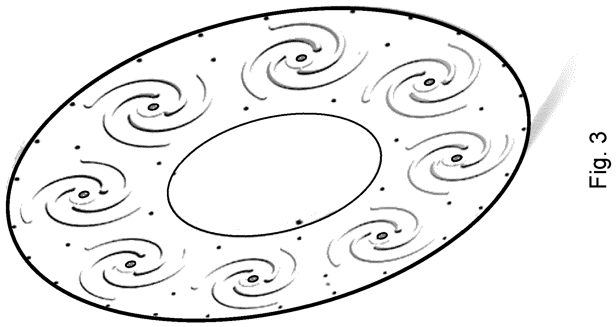

Fig. 3 shows a third example of an article according to the disclosure, wherein another upright three-dimensional representation of an article is shown. The article of Fig. 3 is characterized by having a ring shape comprising a plurality of vortex recesses. These vortex recesses are oriented with at least one vortex recess of the plurality vortex recesses in a vortex-like structure converging to a point for each subset of at least one vortex recess of the plurality of vortex recesses, on the surface of the article. Fig. 3 further shows that a vacuum/underpressure opening may be provided in each of these converging points in between the vortex recesses. This type of recess structure on the surface of the article allows for better thermal distribution of the object that is being carried during processing thereof.

The articles of Figs. 1, 2 and 3 are particular examples of articles which are beneficial use cases of articles manufactured according to the disclosure. Namely, these articles, when receiving/carrying wafers for processing in a process chamber, it must be assured that the wafers remain in the exact position and orientation, and do not translate or tilt during the process. That could have disastrous effects on the final products made out of the wafers. Furthermore, articles for such use cases may be required to be extremely flat and form-stable for properly carrying the wafer.

As shown in Fig. 3, but not shown in Figs. 1 and 2, the article may also comprise vacuum/underpressure openings, which could create a vacuum/underpressure between the wafer and the article, thereby creating a force keeping the wafer in its position and orientation. For instance, in Fig. 1 the ring shaped recess may even be used as vacuum/underpressure channel, whereas in Fig. 2 each carrier recess may be provided with a vacuum/underpressure opening.

Alternatively, the articles of Figs. 1-3 may be concave shaped, such that the object is only carried on the outer perimeter of the article. This concave shape may be very subtle, wherein the center is only a few 10ths of micrometers deeper than the outer perimeter of the article. For instance, for the article of Fig. 1 that could mean that the wafer is carried by the outer perimeter of the inner disc, whereas for the article of Fig. 2 the outer perimeter of each carrier recess would be intended to carry an object.

Since the articles, or susceptors, as shown in Figs 1-3, are intended to be carrying wafers, the articles have dimensions that approximately match those of a standardized wafer, preferably the articles are just slightly larger than the wafer. Typical sizes of wafers may be 25 mm, 51 mm, 76 mm, 100 mm, 125 mm, 200 mm, 300 mm, or even 450 mm, and thus corresponding sizes of the articles are likewise.

Another feature according to the disclosure is that the articles of Figs. 1-3 may also be at least partially coated with a coating layer, preferably made of SiC. Such a coating layer should have a thickness in a range of 1-500 µm, preferably in a range of 10-250 µm, most preferably in a range of 50-200 µm.

The coating layer has at least two effects; first, it fills some of the pores (on the surface) of the article, thereby changing the macroscopic material properties slightly. Second, it ensures that a uniform layer of material is present, which is better to receive an object. Namely, it creates a flatter surface and a greater contact surface between the article and the object.

Because the coating layer is made of the same material as the article the bonding strength is much better between the two and delamination of the coating layer becomes less of an issue.

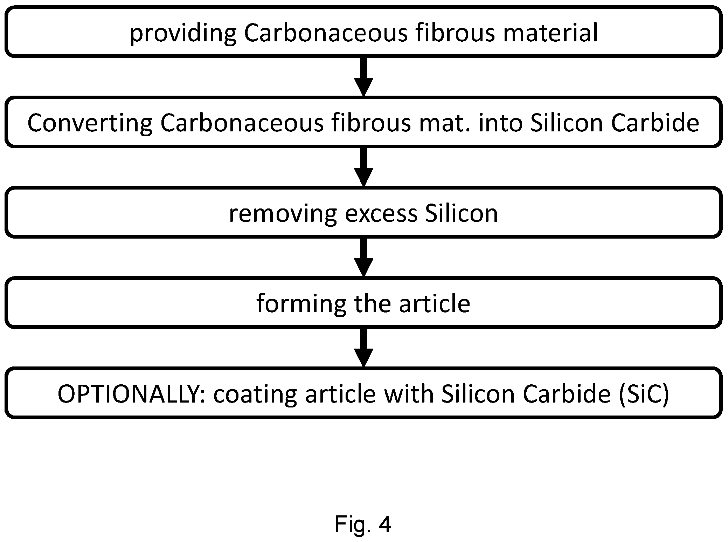

Next, an example of the steps and an example of an order or sequence of these steps is shown in Fig. 4. As can be understood by the expert in the field, providing the carbonaceous fibrous material would always be the first step of the method according to the disclosure. However, the following steps do not necessarily need to follow the order as shown in Fig. 4.

In the example, of Fig. 4 the carbonaceous (C) fibrous material is converted into Silicon Carbide (SiC) with the techniques already disclosed in the beginning of the "detailed description". Thereafter, the article is formed into its final shape dependent on the actual use case of the article. A few examples of such shapes have been given in Fig. 1-3; however these are not meant to be limiting the specific form of the article. For instance, some process reactors may require square-shape articles for holding square shaped objects. Additionally, forming can be understood to be any technique such as machining, molding, etching, or any other method of shaping an object.

Lastly, dependent on which conversion reaction was used to convert the carbonaceous fibrous material into SiC, there might be excess Silicon on or inside the pores of the article. In this last step, the excess of Silicon is removed from the article, ensuring the high final purity of the article. Note that, such a step may occasionally also remove some unconverted Carbon, however, such step is not per se intended to do so.

With this method, articles can be manufactured that have a more form-stable shape due to the lack of internal interfaces, since they are made of a substantially pure material. Furthermore, since the articles comprise porous structures having internal arrangements corresponding to the starting carbonaceous fibrous material, their macroscopic material properties are tunable by changing the open porosity value of the article.

The open porosity value can be tuned, by choosing a different carbonaceous fibrous material having a different starting porosity at the start of the method, or alternatively, it could be further tuned by coating the obtained article with a SiC coating layer which partially fills the pores of the article. The latter is shown as an OPTIONAL step in Fig. 4.

The tunability of the open porosity results in the tunability of several macroscopic material properties of the article of the disclosure. Especially, the tunability of the thermal properties is beneficial for the above-described use cases and the highlighted use cases of Figs. 1-3. These thermal properties make sure that the article is form-stable, does not warp, does not break, and can be made to match the object that is being carried by the article.

Providing a coating layer on the article can offer a more uniform surface for the object to be received on. Furthermore, it allows to (slightly) tune the macroscopic parameters after manufacturing the article, as the coating layer would fill the pores (on the surface of the article).

Being able to tune the (surface) porosity has another advantage, when a vacuum/underpressure is applied to the non-object-carrying side. Namely, in that case contaminants and other debris would obtain a force directing it into the article. The pores may then act as a filter, capturing the contaminants. By tuning the (surface) porosity, specific contaminants may be selected for, giving the article another beneficial advantage over prior art articles.

It should be understood that a coating layer may be provided by Chemical Vapor Deposition (CVD), Chemical Vapor Infiltration (CVI), sputtered, deposited with atomic layer deposition, or grown epitaxially. Therefore, the coating layer does not comprise any fibers or fibrous-like structure, but rather is a uniform layer of coating material.

On the other hand, the carbonaceous fibrous material is a fibrous structure comprising an interlaced network of individual carbon fibers. The material is typically pliable, because the network of fibers is not cross-linked or interconnected. In some examples, the fibers may be neatly oriented parallel and orthogonal to each other. They may even be oriented at an angle with respect to each other. However, in another example the fibers may be randomly oriented, such that no organized structure may be identifiable. Because of this interlacing of fibers, the carbonaceous fibrous material intrinsically comprises pores. Dependent on the exact number and/or distribution of fibers and the orientation, the pore size may differ. The varieties of carbonaceous fibrous material may be chosen as different starting materials for the method according to the disclosure. In a preferred example, the carbonaceous fibrous material is a graphite fibrous material.

In the table below an overview of the obtained material properties of the articles obtained with the method according to the disclosure is shown in comparison with prior art materials.

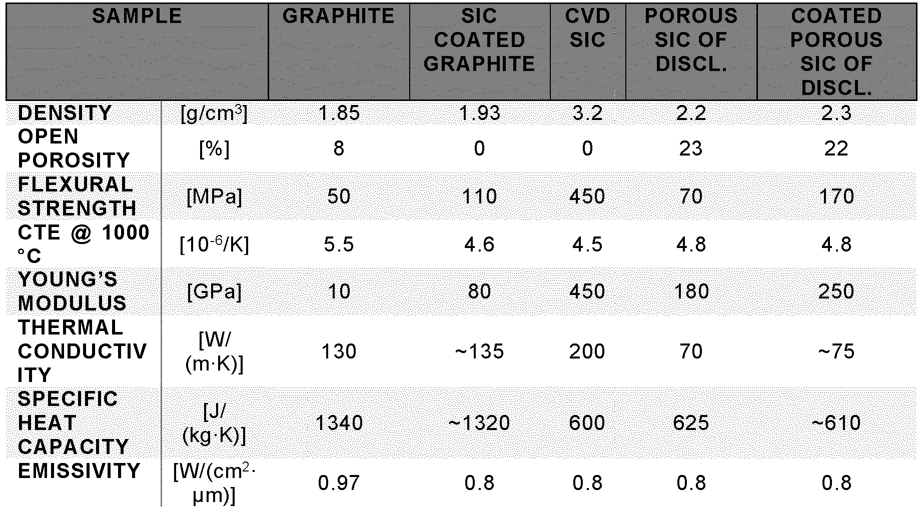

As can be observed from the table, the coated porous SiC article material is closest to the density of pure silicon wafers, which is 2.33 g/cm³. The existing alternatives of SiC coated graphite and CVD SiC are either too low or too high, respectively.

The second material property is the open porosity, which affects the other material properties presented in this table.

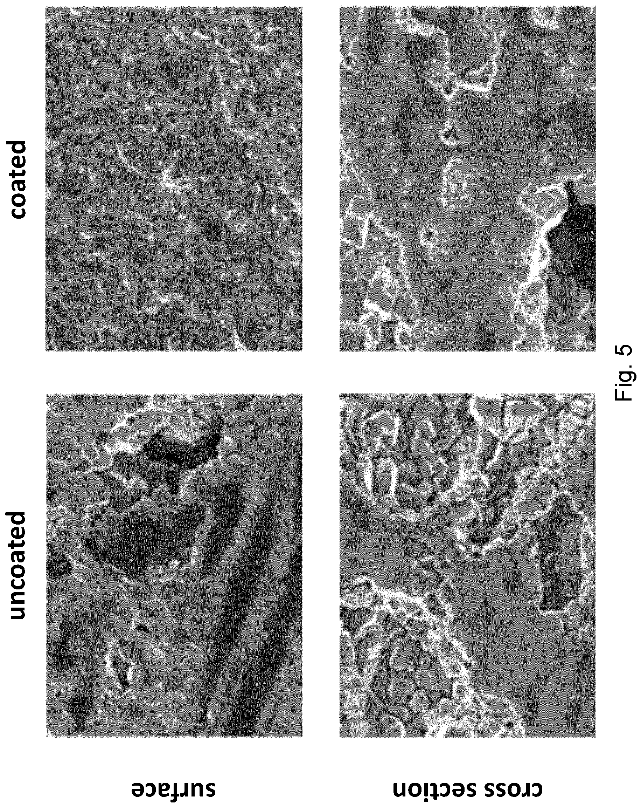

In Fig. 5, four electrographs are shown, wherein the surfaces of uncoated and coated articles are presented in the top row, respectively. Herein, it can be seen that the uncoated article's surface comprises pores, shown as darker spots, whereas the coated articles have a more uniform surface (no larger dark spot visible). The expert in the field will notice that small grains or crystals are visible in both electrographs. These are inevitable and the grain/crystal size will depend on the specific technique that is used to convert the carbonaceous fibrous material into SiC and/or on the specific technique that is used for coating the article.

In the second row of Fig.5 , cross-sections are shown of the same two articles (uncoated and coated), wherein the porous structure on the inside is present. These two electron graphs look alike and show the internal arrangement corresponding to a fibrous material, being the same/similar arrangement of voids and solid material as the starting carbonaceous fibrous material.

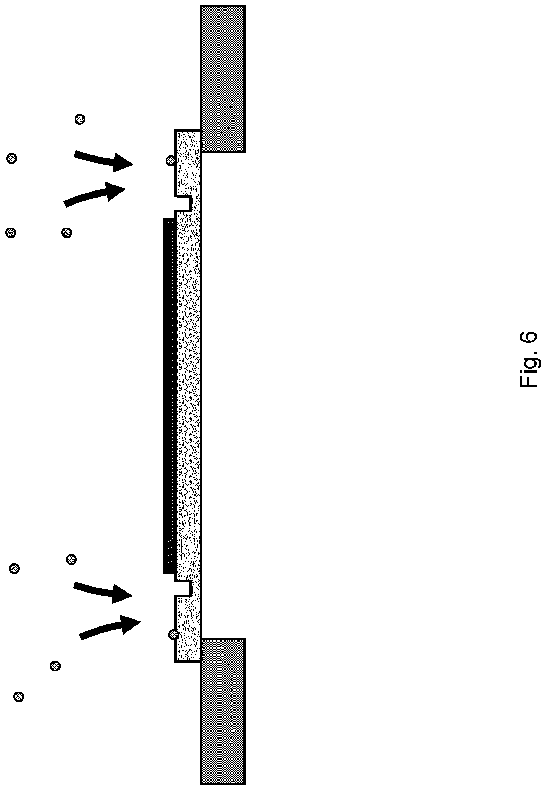

In Fig. 6, a cross-section of the article of Fig. 1 is shown, which is positioned inside a processing chamber. Underneath the article a vacuum/underpressure is applied compared to the atmosphere above the article. The article is carrying an object smaller than the circular recess.

Due to the processing contaminants that are formed or are present in the processing chamber (being above the article), because of the presence of a vacuum/underpressure, these contaminants experience a force drawing them towards parts of the article which are not carrying the object. In Fig. 6 this is shown being the outer ring of the article. This force is generated because of the open porosity of the article, which allows gas molecules to pass through the article, however the pore size is such that large contaminants (being a cluster of molecules) are unable to pass (completely) through. That way, the contaminants are captured in the pores of the article, allowing the process on the object to be more effective and uniform.

Only after processing, the contaminants may be released from the article by inverting the pressure difference, such that a lower pressure is present above the article and a higher pressure underneath the article. This would actively drive the contaminants out the pores of the article again, and since there is no object that is being processed in the chamber, no harm is done.

Please note that for describing Fig. 6 the wording "above" and "underneath" has been used with reference to the figure. The articles according to the disclosure may, however, be positioned to receive an object with their respective other surface. In other words, these articles can be used in two ways and their respective function has remained independent of orientation.

Key in the method according to the disclosure is that there is only little residual carbon material left inside the article, such that most (90+%) is converted. The amount of carbon material remaining inside the article is such a small amount that no individual strands of the original material are identifiable. One could visualize that a prior art article would have a cluster of carbon atoms remaining which can be related back to the original fiber strand, wherein the orientation and path of the fiber correspond with the cluster of carbon atoms along a great portion of its original length. The article of the current patent application, however, does not have such clusters of carbon atoms which could be traced back to the original fiber. It may thus be understood as sporadic clusters of carbon atoms, which no longer represent the orientation or path of the original fiber.

All in all, the articles and the corresponding method of manufacturing as exemplified and clarified by the Figs. 1-5, provides an article which is of high purity and therefore experiences less internal stress, giving the article a stable form even during high-temperature cycling. Such articles are beneficial as susceptors or wafer carriers in process chambers, such that a wafer can be maintained in its correct position and orientation throughout the entire process.

### METHODS OF MEASURING MATERIAL PROPERTIES

The values obtained in the previously presented table have been measured on the article materials obtained according to the method of the disclosure with and without additional SiC coatings of varying thicknesses. Different samples have been measured, wherein the extremes were taken as the boundaries presented in the table.

The density has been obtained by an ASTM standard measurement according to ASTM C559-16 , wherein the bulk density only is determined by measurement of geometric dimensions and mass.

The open porosity is obtained by an ASTM standard measurement according to ASTM D6226, wherein the pore size distribution is determined by physical adsorption, wherein a gas is adsorbed per unit mass of the sample as a function of pressure at a controlled, constant temperature.

The flexural strength of the article material is determined by an ISO standard measurement according to ISO 7500-1, wherein the material is bend at three points.

The coefficient of thermal expansion (CTE) is determined by an ASTM standard measurement according to ASTM D3418, wherein the measurement was performed at 1000 °C.

The Young's modulus is determined by an ASTM standard measurement according to ASTM E1876-15, wherein the elastics modulus is determined by a thin wall C-ring method, measured at room temperature (25 °C).

The thermal conductivity is determined by ASTM and ISO standard measurements according to ASTM E1461 and ISO 13826, wherein a Laser Flash system automatically determines the thermal conductivity using the measured (or separately entered) specific heat capacity and thermal diffusivity, with separately entered density data. The specific heat capacity is measured by ASTM and ISO standard measurements according to ASTM E1461 and ISO 13826, utilizing differential scanning calorimetry, measured at room temperature (25 °C).

The emissivity is determined by standard measurement, wherein a blackbody reference is used with an FTIR spectrometer measured at room temperature (100 °C).

The panels in Fig. 5 have been obtained by measurements in a scanning electron microscope at magnifications of x1000 at an accelerating voltage of 10 keV according to ISO norm 9001 & ISO 14001.

The surface measurements were performed by simply taking the article and placing it in the electron microscope, whereas the cross-sections of the articles were obtained by scribing the article with and subsequently breaking it, such that an electron micrograph could be taken along the break line.

## Claims

1. An article configured for receiving an object for thermal processing, preferably said object being a semiconductor wafer, wherein the article comprises a porous structure having an internal arrangement corresponding to a fibrous material, said article material being silicon carbide (SiC).

2. The article according to claim 1, being an article for a process chamber for thermal processing, having an upper surface and a lower surface, wherein the upper surface is configured for receiving the object, preferably wherein the article comprises an inner disc and an outer ring, wherein inner disc is configured for receiving the object.

3. The article according to any of the preceding claims, wherein the article is a wafer carrier or a susceptor.

4. The article according to any one of the preceding claims, wherein the article is at least partially covered by a silicon carbide (SiC) coating layer.

5. The article according to claim 4, wherein a thickness of the silicon carbide (SiC) coating layer is in a range of 1-500 µm, preferably in a range of 10-250 µm, most preferably in a range of 50-200 µm.

6. The article according to claim 5 at least depending on claim 2, wherein the coating layer is provided on the upper and/or lower surface of the article, preferably is provided on the outer ring.

7. The article according to any one of the preceding claims, wherein the amount of free Carbon (C) is less than 10%wt, preferably less than 5%wt, more preferably less than 2%wt and the amount of free Silicon (Si) is less than 10%wt, preferably less than 5%wt, more preferably less than 2%wt, most preferably less than 1%wt.

8. The article according to any one of the preceding claims, wherein an amount of trace metal is less than 100 ppm, preferably less than 50 ppm, more preferably less than 10 ppm.

9. The article according to any of the preceding claims, wherein the porosity of the article ranges from 5% to 50%, preferably 10% to 40%, more preferably from 15% to 30%.

10. The article according to any of the preceding claims, wherein the density of the article ranges from 1.6 g·cm⁻³ to 3.2 g·cm⁻³, preferably ranging from 2.0 g·cm⁻³ to 3.0 g·cm⁻³, most preferably ranging from 2.2 g·cm⁻³ to 2.5 g·cm⁻³.

11. The article according to any of the preceding claims, wherein the CTE of the article ranges from 4.0·10^{- 6} to 5.5·10⁻ 6 K⁻¹, preferably ranging from 4.5·10⁻⁶ to 5.0·10⁻⁶ K⁻¹, more preferably being 4.8·10⁻⁶ K⁻¹, wherein the CTE is measured at 1000 °C.

12. The article according to any of the preceding claims, wherein the Young's modulus of the article ranges from 80 to 450 GPa, preferably ranging from 150 to 300 GPa

13. A method of manufacturing an article, having an upper surface and a lower surface, wherein the upper surface is configured to receive an object for thermal processing, preferably said object being a semiconductor wafer, the method comprising the steps of:
- providing a porous carbon (C) material, preferably a carbonaceous fibrous material;
- converting substantially all Carbon (C) of the material into Silicon Carbide (SiC) utilizing one or more of the group comprising: Chemical Vapor Reaction (CVR), Liquid Infiltration Reaction (LIR), Liquid Phase Epitaxy (LPE), and Molecular Beam Epitaxy (MBE);
- removing excess Silicon (Si);
- forming the article, such that an object, preferably a semiconductor wafer, can be received.

14. The method of manufacturing an article according to claim 13, wherein the step of forming the article is performed before the step of converting substantially all Carbon (C) into Silicon Carbide (SiC) and/or the step of removing the excess Silicon (Si) from the article is performed after the step of forming the article.

15. The method of manufacturing an article according to claims 13-14, further comprising a step of providing a coating of Silicon Carbide (SiC) on at least part of the article.
